Europäisches Patentamt

European Patent Office

Office européen des brevets

(11) Veröffentlichungsnummer: **0 379 120**
**A2**

## (12) EUROPÄISCHE PATENTANMELDUNG

(21) Anmeldenummer: **90100750.0**

(22) Anmeldetag: **15.01.90**

(51) Int. Cl.5: **G03F 7/09**

(30) Priorität: **23.01.89 DE 3901865**
**23.01.89 DE 3901866**

(43) Veröffentlichungstag der Anmeldung:
**25.07.90 Patentblatt 90/30**

(84) Benannte Vertragsstaaten:
**AT DE FR GB IT NL**

(71) Anmelder: **Siemens Aktiengesellschaft**
**Wittelsbacherplatz 2**
**D-8000 München 2(DE)**

(72) Erfinder: **Nölscher, Christoph, Dr.**
**Hegelstrasse 4**
**D-8000 München 83(DE)**
Erfinder: **Mader, Leonhard, Dr.**
**Defreggerstrasse 17**
**D-8012 Ottobrunn(DE)**
Erfinder: **Schneegans, Manfred, Dr.**
**Johann-Strauss-Strasse 34**
**D-8011 Vaterstetten(DE)**

(54) **Verfahren zur Strukturierung einer Photolackschicht durch optische Lithographie bei der Herstellung integrierter Schaltungen in einem Substrat.**

(57) Zur Verringerung reflexionsbedingter Strukturgrößenschwankungen in einer auf einem Halbleiterschichtaufbau angeordneten Photolackschicht wird unter die Photolackschicht eine Antireflexschicht aus einem optisch dichten Material aufgebracht. Als Antireflexschicht wird insbesondere eine gesputterte TiN-Schicht verwendet. Das Verfahren ist bei der Herstellung integrierter Schaltungen einsetzbar.

FIG 4

EP 0 379 120 A2

## Verfahren zur Strukturierung einer Photolackschicht durch optische Lithographie bei der Herstellung integrierter Schaltungen in einem Substrat.

Die Erfindung betrifft ein Verfahren zur Strukturierung einer Photolackschicht durch optische Lithographie bei der Herstellung integrierter Schaltungen in einem Substrat.

Bei der Herstellung integrierter Schaltungen wird ein Halbleiterschichtaufbau, der als oberste Schicht eine Photolackschicht aufweist, durch eine Photomaske belichtet. Ein Teil des zur Belichtung verwendeten Lichtes wird in der Photolackschicht absorbiert. Ein Teil des Lichtes wird an der Grenzschicht der Photolackschicht zur darunterliegenden Schicht reflektiert. Ein Teil dringt in die unter der Photolackschicht liegenden Schichten ein und wird wiederum an Grenzschichten teilweise reflektiert. Das an Schichtgrenzen reflektierte Licht strahlt von der Rückseite wieder in die Photolackschicht ein. Dadurch kommt es zu einer unerwünschten zweiten Belichtung der Photolackschicht, die je nach Interferenz- bzw. Topographiebedingung Intensitätsschwankungen und damit Strukturgrößenschwankungen zur Folge hat.

Zur Minderung der Strukturgrößenschwankungen bei der Strukurierung von Aluminium ist es bekannt (s. z. B. L. Mader, D. Widmann, W. G. Oldham, "Reduction of Linewidth Variations in Optical Projection Printing", Microcircuit Engeneering, 28 -30.09.1981, Lausanne, Schweiz, p. 105, M. Rocke, M. Schneegans, J. Vac, Sci. Technol. B 6 (1988), p. 113) Antireflexschichten aus amorphem Silizium oder TiN zu verwenden, deren Schichtdikke so gewählt wird, daß die Reflektivität in den Photolack minimal ist.

Zur Verminderung der Strukturgrößenschwankungen infolge von Reflektionen an Silizium, siliziumhaltigen Legierungen oder Siliziden gibt es bisher keine befriedigende Lösung. Der Einsatz eines Photolackes mit erhöhter nicht bleichender Absorption (dyed resist) hilft bei schwachen bis mittleren Strukturgrößenschwankungen. Bei starken Strukturgrößenschwankungen können aufgeschleuderte hoch absorbierende Lackschichten als Antireflexschichten verwendet werden. Falls sie nass entwickelt werden, limitiert die lokale Überentwicklung über der Topographie die Anwendung. Für eine Strukturierung durch ein Trockenätzverfahren ist eine hinreichend ätzresistente Lackmaske und eine nur für die Antireflexschicht-Strukturierung zu benützende Ätzanlage erforderlich.

Eine weitere Möglichkeit, Strukturgrößenschwankungen in der Herstellung integrierter Schaltungen zu berücksichtigen, besteht darin, entweder Designs mit größeren Toleranzen und damit größerer Fläche zu verwenden oder die Designregeln zu verletzen, was zu Ausbeuteminderungen führt.

Der Erfindung liegt die Aufgabe zugrunde, ein Verfahren zur Strukturierung einer Photolackschicht anzugeben, bei dem für Photolackschichten auf beliebigem Untergrund Strukturgrößenschwankungen infolge von Interferenzeffekten vermieden werden.

Das Verfahren soll insbesondere geeignet sein zur Reduktion der Strukturgrößenschwankungen bei der Strukturierung einer über einer Molybdän-Silizium-Schicht angeordneten Photolackschicht.

Die Aufgabe wird erfindungsgemäß durch ein Verfahren der eingangs genannten Art dadurch gelöst, daß unter die Photolackschicht eine Antireflexschicht aus einem optisch dichten Material aufgebracht wird.

Die Verwendung einer Antireflexschicht aus einem optisch dichten Material unter der Photolackschicht bewirkt, daß bei der Belichtung Licht, das in der Photolackschicht nicht absorbiert wurde, im wesentlichen in der Antireflexschicht ab sorbiert wird. Dadurch wird die zurückreflektierte Intensität stark reduziert. In jedem Fall ist die in den Photolack zurückreflektierte Intensität substratunabhängig, da es sich nur um Reflexionen in oder an der Antireflexschicht handelt. Bei hoher optischer Dichte sind Dickenschwankungen der Antireflexschicht unkritisch. Ferner muß die Dicke der Antireflexschicht nicht dem jeweiligen Substrat angepaßt werden. Die Verwendung einer Antireflexschicht aus einem optisch dichten Material ist auch auf Schichten schwankender Reflektivität möglich, wie z. B. schwankende Aluminium- oder Molybdän-Silizium- Reflektivität, schwankende Schichtkörnigkeit, schwankende Oxidschichtdicken unter der Antireflexschicht, Bereiche verschiedener Reflektivität unter der Antireflexschicht.

Es liegt im Rahmen der Erfindung, eine Antireflexschicht aus gesputtertem TiN zu verwenden. Eine solche Antireflexschicht ist für Belichtungswellenlängen zwischen 240 mm und 440 mm gut wirksam und hat für Licht mit einer Wellenlänge von 436 nm einen Brechungsindex $n + ik = 1{,}74 + i\,1{,}02$. Die Wellenlänge 436 nm wird bei der Stepperlithographie häufig verwendet.

Es liegt ferner im Rahmen der Erfindung, die Antireflexschicht auf einer siliziumhaltigen Schicht zu erzeugen.

Es liegt insbesondere im Rahmen der Erfindung, vor dem Aufstäuben der TiN-Schicht eine siliziumhaltige Schicht durch Sputtern von Metall-Silizid, insbesondere von Molybdän-Silizid, herzustellen. Eine optimale Antireflexwirkung wird hier erzielt bei Verwendung einer TiN-Schicht, die in einer Dicke von 30 bis 80 nm aufgestäubt wird.

Im folgenden wird die Erfindung anhand der Figuren näher erläutert.

Fig. 1 zeigt schematisch einen Schichtaufbau mit einer Antireflexschicht und einer Photolackschicht.

Fig. 2 zeigt das Ergebnis von Simulationsrechnungen für die Reflektivität einer optisch dichten Unterlage unter dem Photo lack in den Lack als Funktion des komplexen Brechungsindexes n + ik der optisch dichten Unterlage.

Fig. 3 zeigt das Ergebnis einer Simulationsrechnung für die Reflektivität einer optisch dichten Unterlage unter dem Photolack in Luft als Funktion des komplexen Brechungsindexes n + ik der optisch dichten Unterlage.

In Fig. 4 ist der Vergleich zwischen dem Ergebnis einer Simulationsrechnung der Reflektivität einer TiN-Schicht als Funktion der Schichtdicke und gemessenen Reflektivitäten einer solchen Schicht dargestellt.

In Fig. 5 ist das Ergebnis einer Simulationsrechnung dargestellt für die Reflektivität an einer TiN-Schicht als Funktion der Schichtdicke einer darunterliegenden $SiO_2$-Schicht.

In Fig. 6 sind Meßergebnisse dargestellt der Reflektivität einer TiN-Schicht auf Aluminium als Funktion der Schichtdicke für verschiedene Lichtwellenlängen.

In Fig. 7 sind Meßergebnisse dargestellt für die Reflektivität einer TiN-Schicht auf Silizium als Funktion der Schichtdicke für verschiedene Lichtwellenlängen.

In Fig. 8 sind Meßergebnisse der Reflektivität (in %) von TiN-Schichten auf einem Molybdän-Silizium-Substrat in Abhängigkeit der Schichtdicke angegeben.

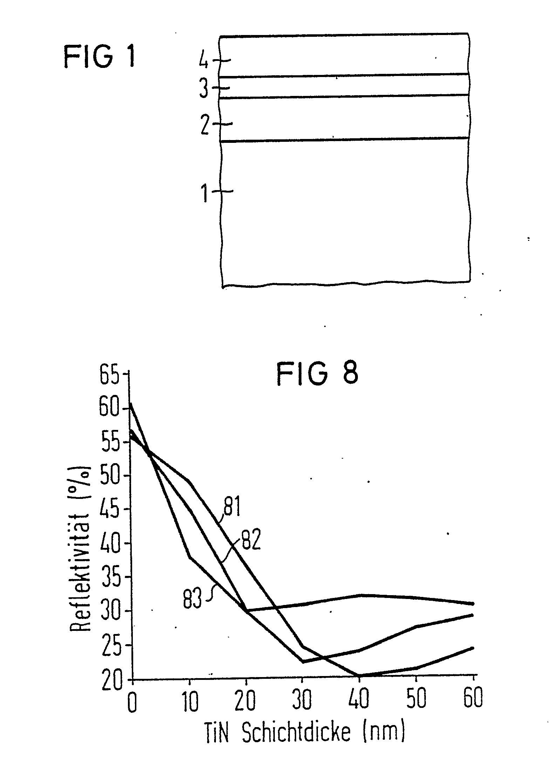

In Fig. 1 ist ein Schichtaufbau dargestellt. Der Schichtaufbau enthält ein Substrat 1 aus z. B. Silizium. Auf dem Substrat 1 ist eine Schicht 2 angeordnet, die z. B. aus $SiO_2$, Molybdän-Silizium, einem Silizid oder Aluminium besteht. Auf der Schicht 2 ist eine Antireflexschicht 3 angeordnet. Die Antireflexschicht 3 besteht z. B. aus TiN. Auf der Antireflexschicht 3 ist eine Photolackschicht 4 angeordnet.

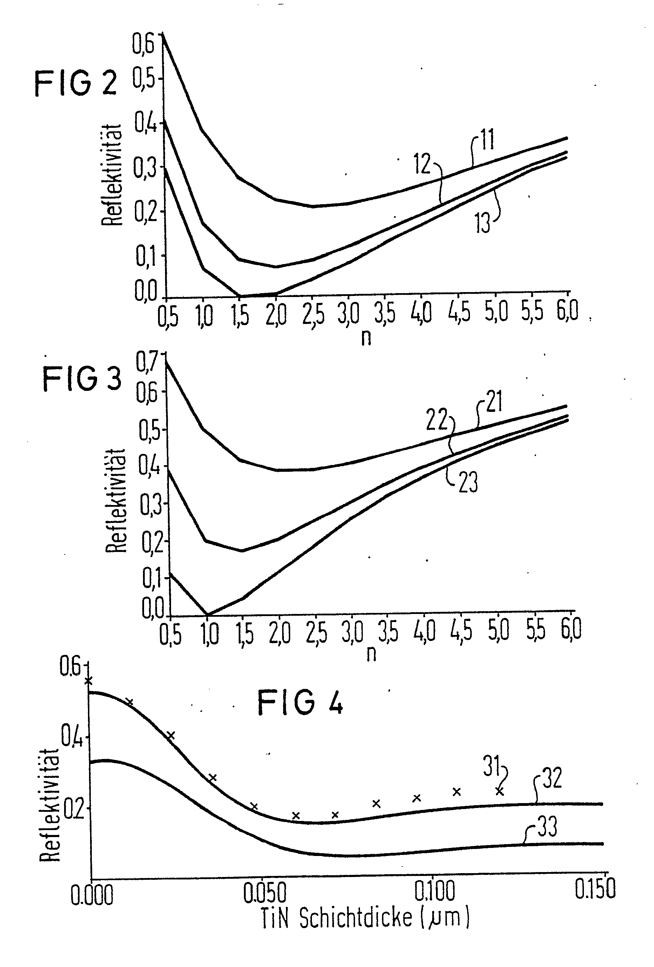

In Fig. 2 ist das Ergebnis einer Simulationsrechnung dargestellt für die Reflektivität eines optisch dichten Substrats in einen Photolack als Funktion des Real teils n des komplexen Brechungsindexes n + ik des optisch dichten Substrats. Parameter für die Kurvenschar ist der Imaginärteil k des komplexen Brechungsindexes n + ik des optisch dichten Substrats. Für die Kurve 11 gilt k = 2,0; für die Kurve 12 k = 1,0 und für die Kurve 13 k = 0,1. Für den Photolack wurde ein Brechungsindex n = 1,7 zugrunde gelegt. Als Reflektivität wird der Quotient aus der reflektierten Lichtintensität und der eingestrahlten Lichtintensität verstanden. Das Ergebnis zeigt, daß durch Wahl eines Materials mit einem geeigneten Brechungsindex für die unter einer Photolackschicht angeordnete Schicht die Reflektivität in den Photolack, die Ursache für Strukturgrößenschwankungen aufgrund von Interferrenzeffekten ist, drastisch reduziert werden kann.

In Fig. 3 ist das Ergebnis einer Simulationsrechnung dargestellt für die Reflektivität eines optisch dichten Substrats in Luft. Die Reflektivität ist so definiert wie zu Fig. 1. Die Reflektivität ist als Funktion des Realteils n des komplexen Brechungsindexes n + ik des optisch dichten Substrats aufgetragen. Parameter für die Kurvenschar ist der Imaginärteil k des komplexen Brechungsindexes n + ik. Für die Berechnung der Kurve 21 wurde k = 2,0 zugrundegelegt, für die Berechnung der Kurve 22 k = 1,0 und für die Berechnung der Kurve 23 k = 0,1.

In Fig. 4 ist die experimentielle Überprüfung einer Simulationsrechnung der Reflektivität einer TiN-Schicht auf einem Molybdän-Silizium-Substrat als Funktion der Schichtdicke der TiN-Schicht dargestellt. Das Meßergebnis wurde als Punkte 31 dargestellt. Die Kurve 32 stellt das Ergebnis einer Simulations dar, die die Reflektivität in Luft berechnet. Die Kurve 33 ist für die Reflektivität in Photolack berechnet. Für die Simulationsrechnungen wurde für die TiN-Schicht ein Brechungsindex von 1,74 - i 1,0 zugrundegelegt. Für das Molybdän-Silizium-Substrat wurde ein Brechungsindex von 4,0 - i 2,9 verwendet. Die Reflektivität ist wie bei den vorhergehenden Figuren definiert. Der Brechungsindex der TiN-Schicht liegt in dem Bereich, für den die in Fig. 1 und 2 dargestellten Simulationsrechnungen eine reduzierte Reflektivität vorhersagen. Für TiN-Schichten mit einer Dicke von mehr als 50 nm wird dieses Ergebnis experimentiell bestätigt.

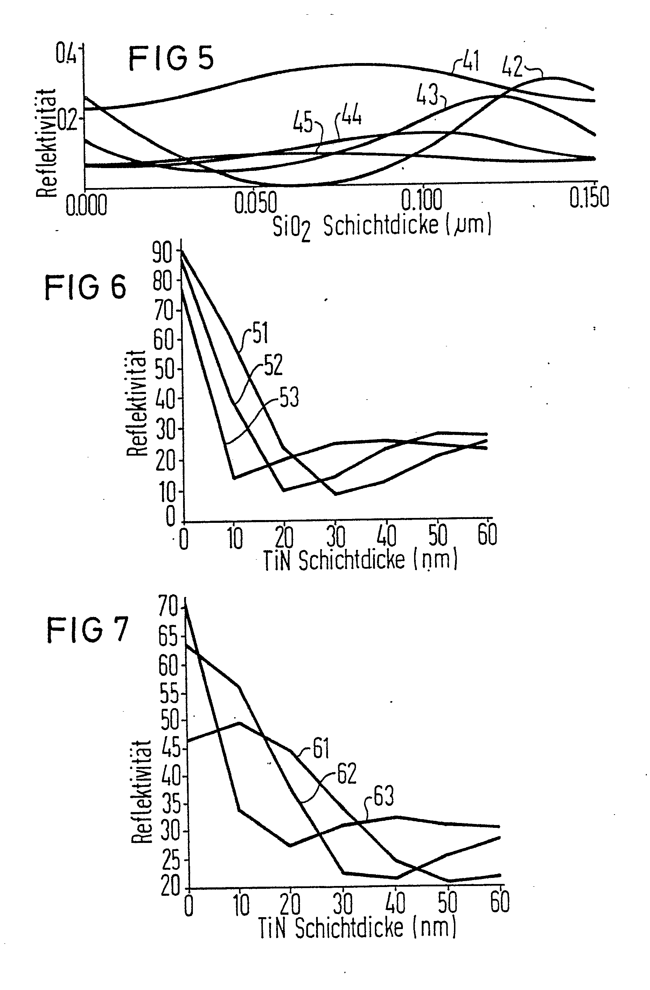

In Fig. 5 ist das Ergebnis einer Simulationsrechnung dargestellt, in der die Reflektivität an einer TiN-Schicht berechnet wurde, die unter einer Photolackschicht und über einer $SiO_2$-Schicht angeordnet ist. Die $SiO_2$-Schicht ist auf einem Siliziumsubstrat angeordnet. Die Reflektivität, die wie in den vorhergehenden Figuren definiert ist, ist als Funktion der Schichtdicke der $SiO_2$-Schicht dargestellt. Die Kurve 41 zeigt das Rechenergebnis für eine TiN-Schichtdicke von 0 nm, die Kurve 42 von 25 nm, die Kurve 43 von 50 nm, die Kurve 44 von 75 nm und die Kurve 45 von 100 nm. Das Ergebnis zeigt, daß die Kurven 44 und 45 weitgehend unabhängig von der Dicke der $SiO_2$-Schicht sind. Das bedeutet, daß für TiN-Schichten mit einer Dicke von mindestens 75 nm darunterliegende Schichten von schwankender Dicke keinen signifikanten Einfluß auf die Reflektivität haben.

In Fig. 6 sind Meßergebnisse dargestellt für die Reflektivität einer TiN-Schicht, die unter einer Photolackschicht auf Aluminium angeordnet ist. Die Reflektivität, die wir in den vorhergehenden Figuren definiert ist, ist als Funktion der TiN-Schichtdicke gemessen. Die Kurve 51 zeigt das Ergebnis einer Messung mit Licht der Wellenlänge 436 nm, die Kurve 52 365 nm und die Kurve 53 248 nm. Es zeigt sich, daß die Antireflexwirkung der TiN-Schicht für Schichtdicken ab 20 nm für alle drei untersuchten Wellenlängen, die Wellenlängen entsprechen, die bei der Photolithographie verwendet werden, gut ist.

In Fig. 7 sind Meßergebnisse der Reflektivität einer TiN-Schicht auf einem Siliziumsubstrat mit darüberliegender Photolackschicht als Funktion der Schichtdicke der TiN-Schicht aufgetragen. Für die Kurve 61 wurde Licht einer Wellenlänge 436 nm verwendet, für die Kurve 62 365 nm und für die Kurve 63 248 nm. Es zeigt sich, daß für Schichtdicken über 30 nm auch für die kürzeren untersuchten Wellenlängen noch eine annehmbare Antireflexwirkung der TiN-Schicht auftritt. Die Kurve wird bei größeren Schichtdicken ansteigen und den Sättigungsweit wie Kurve 51 erreichen.

In der Fig. 8 sind Meßergebnisse der Reflektivität (in %) von TiN-Schichten in Abhängigkeit der Schichtdicke angegeben. Parameter für die Kurvenschar ist die Wellenlänge des bei der Belichtung verwendeten Lichtes. Die Kurve 81 wurde gemessen bei einer Belichtung mit Licht der Wellenlänge 436 nm, die Kurve 82 mit Licht der Wellenlänge 365 nm und die Kurve 83 mit Licht der Wellenlänge 248 nm. Die TiN-Schichten wurden durch Sputtern (Aufstäuben) auf kaltes Substrat hergestellt. Das Substrat besteht aus Molybdän-Silizium. Fig. 8 ist zu entnehmen, daß die Verwendung einer Antireflexschicht aus TiN zu einer drastischen Reduzierung der Reflektivität führt. D. h., durch Verwendung einer solchen Antireflexschicht werden Verminderungen der Strukturgrößenschwankungen, die auf Reflexionen und Interferenzen zurückgehen, erzielt. Fig. 8 ist weiter zu entnehmen, daß es Schichtdicken gibt, bei denen die Reflektivität einer TiN-Schicht auf Molybdän-Silizium minimal ist. Bei Belichtung mit Licht einer Wellenlänge von 436 nm werden in dem vorliegenden Beispiel für eine Schichtdicke von 40 nm optimale Ergebnisse erzielt.

Durch die Verwendung einer TiN-Schicht als Antireflexschicht auf Molybdän-Silizium wird die Reflektivität (das ist der Quotient aus der reflektierten Lichtintensität und der eingestrahlten Lichtintensität mindestens halbiert gegenüber dem Wert, der ohne Antireflexschicht erzielt wird.

## Ansprüche

1. Vefahren zur Strukturierung einer Photolackschicht durch optische Lithographie bei der Herstellung integrierter Schaltungen in einem Substrat, **dadurch gekennzeichnet,** daß unter die Photolackschicht (4) eine Antireflexschicht (3) aus einem optisch dichten Material aufgebracht wird.

2. Verfahren nach Anspruch 1, **dadurch gekennzeichnet,** daß die Antireflexschicht (3) durch Aufsputtern von TiN erzeugt wird.

3. Verfahren nach Anspruch 1 oder 2, **dadurch gekennzeichnet,** daß auf das Substrat (1) eine siliziumhaltige Schicht (2) aufgebracht wird, auf der die Antireflexschicht (3) erzeugt wird.

4. Verfahren nach Anspruch 3, **dadurch gekennzeichnet,** daß die siliziumhaltige Schicht (2) als gesputterte Metall-Silizid-Schicht vor dem Aufbringen der Antireflexschicht (3) hergestellt wird.

FIG 1

4

3

2

1

FIG 8

Reflektivität [%]

65
60
55
50
45
40
35
30
25
20

81
82
83

0    10    20    30    40    50    60

TiN Schichtdicke (nm)

FIG 2

FIG 3

FIG 4

FIG 5

FIG 6

FIG 7